# EUROPÄISCHE PATENTSCHRIFT

(11) **EP 3 000 008 B1**
(45) Veröffentlichungstag und Bekanntmachung des Hinweises auf die Patenterteilung: **16.11.2016**
(21) Anmeldenummer: 14716535.1
(22) Anmeldetag: 31.03.2014
(51) Int. Cl.: G06F 13/40, G06F 1/18, H05K 7/14

(54) **ANORDNUNG FÜR EINEN BLADESERVEREINSCHUB**
ARRANGEMENT FOR BLADE SERVER MODULE
ARRANGEMENT POUR MODULE DE SERVEUR LAME

(30) Priorität: 21.05.2013 DE 102013105173
(43) Veröffentlichungstag der Anmeldung: 30.03.2016
(73) Patentinhaber: Fujitsu Technology Solutions Intellectual Property GmbH, 80807 München (DE)
(72) Erfinder: FIETZ, Ralf-Peter, 33104 Paderborn (DE); HESSE, Ronny, 33175 Bad Lippspringe (DE)
(74) Vertreter: Epping - Hermann - Fischer
(86) Internationale Anmeldenummer: PCT/EP2014/056469
(87) Internationale Veröffentlichungsnummer: WO 2014/187595

(56) Entgegenhaltungen:
- US-A1- 2013 027 875
- US-B1- 6 282 087

## Beschreibung

Die Erfindung betrifft eine Anordnung für einen Bladeservereinschub, welcher eine Hauptplatine mit einem Steckverbinder und eine in den Steckverbinder der Hauptplatine eingesteckte Riserkarte aufweist.

Aus der US 2013/027875 A1 ist ein Riserkartenmodul für das Einstecken einer Mehrzahl von Erweiterungskarten bekannt. Jede der Erweiterungskarten weist eine Leiterplatte und eine Halteklammer auf. Die Halteklammer weist einen länglichen Körper auf, der auf der Leiterplatte angeordnet ist.

Ein Bladeserversystem umfasst im Allgemeinen eine Vielzahl von Bladeservereinschüben, die in Form von Einschubmodulen in einen Serverrahmen eingeschoben sind. Bladeservereinschübe sind in der Regel sehr flach und kompakt ausgestaltet und meist vertikal nebeneinander in dem Serverrahmen angeordnet. Bladeservereinschübe weisen in der Regel lediglich eine eigene Hautplatine, Arbeitsspeicher sowie ein bis zwei Festplatten auf. Weitere zum Betrieb benötigte Komponenten wie beispielsweise Stromversorgungen (Netzteile), Netzwerkswitches und/oder Lüfter werden üblicherweise von weiteren im Bladeserversystem angeordneten Anschlussmodulen oder sonstigen Baugruppen bereitgestellt und von den Bladeservereinschüben gemeinsam genutzt. Die elektrische Verbindung zwischen den Bladeservereinschüben und beispielsweise den Anschlussmodulen wird häufig mittels einer Leiterplatte mit geeigneten Anschlüssen realisiert. Eine solche Leiterplatte ist dabei typischerweise in der Mitte des Bladeserversystems hinter den Bladeservereinschüben vertikal angeordnet und wird als Midplane oder Backplane bezeichnet. Eine solche Midplane oder Backplane weist zwei Seiten mit jeweils einer Vielzahl von Anschlüssen in Form von Steckverbindern (Stecker und/oder Buchsen) auf.

Aufgrund der kompakten Bauweise beziehungsweise Formfaktors eines Bladeservereinschubs und der dicht gepackten Anordnung von Komponenten im Inneren eines Bladeservereinschubs gestaltet sich die Erweiterung eines Bladeservereinschubs mit beispielsweise einer Erweiterungskarte schwer. Zusätzlich muss die in der Regel komplexe Kühlung eines Bladeservereinschubs berücksichtigt werden, welche nicht durch die Erweiterungskarte behindert werden sollte. In der Regel werden Erweiterungskarten mit Hilfe sogenannter Riserkarten in einem Bladeservereinschub montiert. Riserkarten sind senkrecht zu einer Hauptplatine eines Bladeservereinschubs in die Hauptplatine eingesteckt.

Die Riserkarte ist in der Regel schwer zugänglich in dem Bladeservereinschub verbaut, sodass das Anstecken einer Erweiterungskarte sich als schwierig erweist, wenn nicht der Bladeservereinschub geöffnet beziehungsweise demontiert wird. Oftmals sind bei der Montage einer Erweiterungskarte an die Riserkarte die Steckkontakte der Riserkarte und/oder der entsprechende Steckverbinder der Erweiterungskarte nicht gut einsehbar, sodass es bei der Montage zu Schäden der Steckkontakte bzw. des Steckverbinders oder anderen Komponenten im Inneren des Bladeservereinschubs kommen kann. Ein weiterer Nachteil bei bestehenden Systemen ergibt sich bei der Demontage einer angesteckten Erweiterungskarte. Wird beispielsweise eine Erweiterungskarte von der Riserkarte demontiert, so ist nicht gesichert, ob die Riserkarte mit abgesteckt wird oder im Steckverbinder der Hauptplatine verbleibt. Verbleibt die Riserkarte beispielsweise an der Erweiterungskarte, so ist die Demontage der Erweiterungskarte und der Riserkarte schwierig und kann Schäden an andere Komponenten hervorrufen.

Eine Aufgabe, die der Erfindung zugrunde liegt, ist es, eine Anordnung für einen Bladeservereinschub zu beschreiben, welche eine sichere Montage und Demontage einer Riserkarte ermöglicht. Bevorzugt soll auch eine sichere Montage und Demontage einer Erweiterungskarte an einer beziehungsweise von einer Riserkarte ermöglicht sein.

Gemäß einem ersten Aspekt der Erfindung wird eine Anordnung für einen Bladeservereinschub beschrieben, welcher eine Hauptplatine mit einem Steckverbinder aufweist. Die Anordnung weist weiterhin eine in den Steckverbinder der Hauptplatine eingesteckte Riserkarte auf. In dem Bladeservereinschub ist im Wesentlichen parallel zu der Hauptplatine ein Trägerblech mit einer ersten Öffnung festgelegt, wobei die erste Öffnung fluchtend mit freiliegenden Steckkontakten der eingesteckten Riserkarte angeordnet ist. Des Weiteren weist die Anordnung ein Halteelement auf. Die Anordnung ist dadurch gekennzeichnet, dass das Halteelement einen Grundkörper mit einer durchgängigen, zweiten Öffnung aufweist. Das Halteelement ist dazu eingerichtet, mittels der zweiten Öffnung formschlüssig auf die Riserkarte aufgeschoben zu werden und mit dem Trägerblech zu verrasten, sodass die Riserkarte mechanisch sicher an dem Trägerblech festgelegt ist und die Steckkontakte der Riserkarte über die zweite Öffnung zugänglich sind.

Die parallele Anordnung des Trägerblechs bedeutet, dass das Trägerblech in einer (Haupt-)Erstreckungsebene parallel zu einer (Haupt-)Erstreckungsebene der Hauptplatine angeordnet ist.

Die Anordnung gemäß dem ersten Aspekt sieht vor, dass die Riserkarte mittels des Halteelements fest und mechanisch sicher mit dem Trägerblech des Bladeservereinschubs verbunden ist. Dabei garantiert das Halteelement, dass die freiliegenden Steckkontakte der Riserkarte über die zweite Öffnung zugänglich sind, sodass beispielsweise eine Erweiterungskarte auf die Riserkarte gesteckt werden kann. Dadurch, dass die Riserkarte an dem Trägerblech festgelegt ist, wird verhindert, dass beim Demontieren einer Erweiterungskarte, welche auf die Riserkarte aufgesteckt ist, die Riserkarte selbst nicht von der Hauptplatine abgesteckt beziehungsweise demontiert wird. Die Riserkarte ist somit stets in die Hauptplatine eingesteckt. In anderen Worten ausgedrückt bedeutet dies, dass die Erweiterungskarte mit eingesteckter Riserkarte nicht als Einheit demontiert werden kann. Eine solche Einheit ist schwieriger in der Handhabung und kann aufgrund der engen und kompakten Bauweise und Anordnung eines Bladeservereinschubs andere Komponenten leicht beschädigen, beispielsweise aufgrund elektrostatischer Aufladung. Zudem ist die Montage (sowohl der Einheit oder separat) schwieriger, da die Riserkarte unten in die Hauptplatine gesteckt werden muss und der in der Regel verdeckte Steckverbinder auf der Hauptplatine gefunden werden muss. Zusätzlich kann eine vertikale Verkippung beziehungsweise ein Verbiegen der Riserkarte verhindert werden, sodass die Riserkarte stets in vertikaler Position, das heißt senkrecht zu der Erstreckungsebene der Hauptplatine, gehalten wird.

Gemäß einer vorteilhaften Ausgestaltung weist die Anordnung weiter eine Erweiterungskarte auf, welche dazu eingerichtet ist, mittels eines Steckverbinders der Erweiterungskarte in die zweite Öffnung des Halteelements zum Verbinden mit den Steckkontakten der Riserkarte derart eingesteckt zu werden, dass die Erweiterungskarte auf einer die zweite Öffnung des Halteelements aufweisenden Seite des Halteelements aufliegt. Dadurch lagert die Erweiterungskarte auf dem Halteelement und es ist möglich, das Gewicht der Erweiterungskarte über das Halteelement an dem Trägerblech abzustützen. Dadurch wird das Gewicht der Erweiterungskarte nicht oder zumindest nicht vollständig auf die Riserkarte übertragen oder abgegeben, welche dadurch entlastet wird. Zusätzlich ist dadurch eine stabile Anordnung der Erweiterungskarte und der Riserkarte gewährleistet, sodass es unter anderem praktisch zu keinen oder nur sehr geringen Schwingungen der Erweiterungskarte und/oder der Riserkarte kommen kann.

Gemäß einer weiteren, vorteilhaften Ausgestaltung sind die freiliegenden Steckkontakte der Riserkarte im Wesentlichen innerhalb der zweiten Öffnung des Halteelements angeordnet. Dadurch sind die Steckkontakte der Riserkarte im Wesentlichen vor Berührung mit anderen Komponenten geschützt.

Gemäß einer weiteren, vorteilhaften Ausgestaltung weist der Grundkörper des Halteelements wenigstens zwei erste, federnde Rastelemente auf und die Riserkarte weist wenigstens zwei Aussparungen auf, sodass die wenigstens zwei ersten Rastelemente beim Aufschieben des Halteelements auf die Riserkarte in den wenigstens zwei Aussparungen verrasten und das Haltelement mechanisch sicher mit der Riserkarte gekoppelt ist. Dies ermöglicht zum einen, dass das Halteelement sicher mit der Riserkarte mechanisch verbunden ist. Zum anderen ist es dadurch möglich, vor dem Einstecken der Riserkarte in die Hauptplatine das Halteelement an der Riserkarte anzubringen beziehungsweise zu montieren. Die Riserkarte und das Halteelement können dann gemeinsam in dem Bladeservereinschub montiert beziehungsweise eingesteckt werden. Dadurch ist eine einfache Montage gewährleistet. Gemäß einer weiteren, vorteilhaften Ausgestaltung weist der Grundkörper des Halteelements wenigstens zwei zweite, federnde Rastelemente zum Verrasten des Halteelements mit dem Trägerblech auf. Damit ist eine einfache Möglichkeit zum Verrasten des Halteelements mit dem Trägerblech aufgezeigt. Das Halteelement kann somit einfach in das Trägerblech eingesteckt beziehungsweise eingeklipst werden und mit diesem verrasten.

Gemäß einer weiteren, vorteilhaften Ausgestaltung weist der Grundkörper des Halteelements wenigstens zwei zweite, federnde Rastelemente zum Verrasten des Halteelements mit dem Trägerblech auf und aus dem Grundkörper des Halteelements sind zwei U-förmige, gegenüberliegende Abschnitte herausgeformt. Dabei sind an einem U-förmigen Abschnitt jeweils ein erstes, federndes Rastelement und jeweils ein zweites, federndes Rastelement angeordnet. Dadurch ist es möglich, dass das Halteelement auf einfache Weise sowohl mit der Riserkarte als auch mit dem Trägerblech verrasten kann. Zusätzlich ist eine einfache Demontage des Halteelements möglich, da sowohl das erste als auch das zweite federnde Rastelement über einen U-förmigen Abschnitt verbunden sind und somit gemeinsam entrastet beziehungsweise entriegelt werden können. Beispielsweise kann das Entriegeln dadurch ermöglicht werden, dass die U-förmigen Abschnitte jeweils ein Griffelement aufweisen, welches manuell zum jeweiligen Lösen verrasteter Rastelemente betätigt werden kann.

Gemäß einer weiteren, vorteilhaften Ausgestaltung ist der Steckverbinder der Erweiterungskarte formschlüssig in der zweiten Öffnung des Halteelements aufnehmbar. Dadurch ist die Erweiterungskarte mechanisch sicher innerhalb des Halteelements festgelegt.

Gemäß einer weiteren, vorteilhaften Ausgestaltung weist das Halteelement an Außenkanten, welche die zweite Öffnung begrenzen, eine oder mehrere Fasen auf. Dadurch ist es beispielsweise möglich, dass ein Steckverbinder in der Erweiterungskarte beim Aufstecken auf die Riserkarte eine richtige Steckposition einnimmt. Dies ist beispielsweise hilfreich, wenn der Steckverbinder der Erweiterungskarte nicht gut einsehbar ist und nur ungefähr in die richtige Position oberhalb der Riserkarte gebracht wird. Aufgrund der Fasen würde der Steckverbinder der Erweiterungskarte dann in die richtige Position gleiten oder rutschen. Das Halteelement erzeugt somit eine Trichterwirkung.

Gemäß einer weiteren, vorteilhaften Ausgestaltung wobei das Halteelement im Bereich der zweiten Öffnung zwei Nuten auf, welche gegenüberliegend angeordnet sind und dazu eingerichtet sind, die Riserkarte seitlich zu umgreifen. Dadurch ist ein seitliches Verkippen oder Verbiegen der Riserkarte im Wesentlichen nicht möglich. Die Riserkarte ist somit seitlich innerhalb oder an dem Halteelement geführt.

Gemäß einer weiteren, vorteilhaften Ausgestaltung der Erfindung ist das Trägerblech ein Seitenteil eines Festplattenkäfigs. Dadurch ist es beispielsweise nicht nötig, zusätzliche konstruktive Maßnahmen zu ergreifen oder zusätzliche Bauteile zu verwenden.

Gemäß einer weiteren, vorteilhaften Ausgestaltung weist die Anordnung wenigstens ein Auflagerelement auf, welches im Servereinschub angeordnet ist und dazu eingerichtet ist, eine in die zweite Öffnung des Halteelements eingesteckte Erweiterungskarte abzustützen. Ein solches Auflagerelement kann beispielsweise im Randbereich der Erweiterungskarte im Inneren des Servereinschubs angeordnet sein. Somit kann beispielsweise eine Erweiterungskarte, welche sich über eine große Fläche im Inneren des Bladeservereinschubs erstreckt, seitlich abgestützt werden, wodurch Schwingungen der Erweiterungskarte im Wesentlichen vermieden werden. Zusätzlich verteilt sich das Gewicht der Erweiterungskarte nicht nur auf das Halteelement und/oder die Riserkarte.

Gemäß einer weiteren, vorteilhaften Ausgestaltung der Erfindung weist das wenigstens eine Auflagerelement parallel zu einer Einsteckrichtung der Erweiterungskarte einen Vorsprung auf und die Erweiterungskarte weist eine oder mehrere Aussparungen auf, wobei beim Einstecken der Erweiterungskarte der Vorsprung des wenigstens einen Auflagerelements formschlüssig in einer entsprechenden Aussparung aufgenommen ist. Dadurch kann zusätzlich sichergestellt werden, dass die Erweiterungskarte beim Einstecken eine korrekte Montageposition einnimmt. Die Erweiterungskarte wird somit beim Einstecken mittels eines Vorsprungs geführt. Die Aussparung kann beispielweise als Kulissenführung für den Vorsprung gesehen werden. Zusätzlich wird beispielsweise eine Bewegung der Erweiterungskarte in einer Richtung parallel zu einer (Haupt-)Erstreckungsebene der Erweiterungskarte verhindert.

Gemäß einer weiteren, vorteilhaften Ausgestaltung ist das Halteelement einstückig und/oder aus einem Kunststoffwerkstoff hergestellt. Somit kann das Halteelement kostengünstig auf einfache Art und Weise, beispielsweise mittels eines Spritzgussverfahrens, hergestellt werden. Weitere vorteilhafte Ausgestaltungen sind in der nachfolgenden, ausführlichen Beschreibung von Ausführungsbeispielen offenbart.

Die Ausführungsbeispiele der Erfindung sind unter Zuhilfenahme der angehängten Figuren nachfolgend beschrieben. In den Figuren sind gleichartige Komponenten unterschiedlicher Ausführungsbeispiele mit gleichen Bezugszeichen versehen. Bereits mit Hilfe von Bezugszeichen beschriebene Merkmale der Ausführungsbeispiele sind nicht zwingend in allen Figuren mit Bezugszeichen versehen.

In den Figuren zeigen:
- Figur 1: eine schematische, dreidimensionale Ansicht einer Anordnung mit einem Halteelement gemäß einem ersten Ausführungsbeispiel,
- Figur 2: eine schematische, dreidimensionale Ansicht des Halteelements gemäß dem ersten Ausführungsbeispiel,
- Figur 3: eine schematische Seitenansicht des Halteelements gemäß dem ersten Ausführungsbeispiel,
- Figur 4: eine schematische Seitenansicht der Anordnung,
- Figur 5: eine schematische, dreidimensionale Ansicht eines Halteelements gemäß einem zweiten Ausführungsbeispiel,
- Figur 6: eine schematische Seitenansicht des Halteelements gemäß dem zweiten Ausführungsbeispiel,
- Figur 7: eine schematische, dreidimensionale Ansicht einer Anordnung mit zwei Auflagerelementen,
- Figur 8: eine schematische, dreidimensionale Ansicht des Auflagerelements und
- Figur 9: eine schematische, dreidimensionale Detailansicht der Anordnung gemäß dem zweiten. Ausführungsbeispiel.

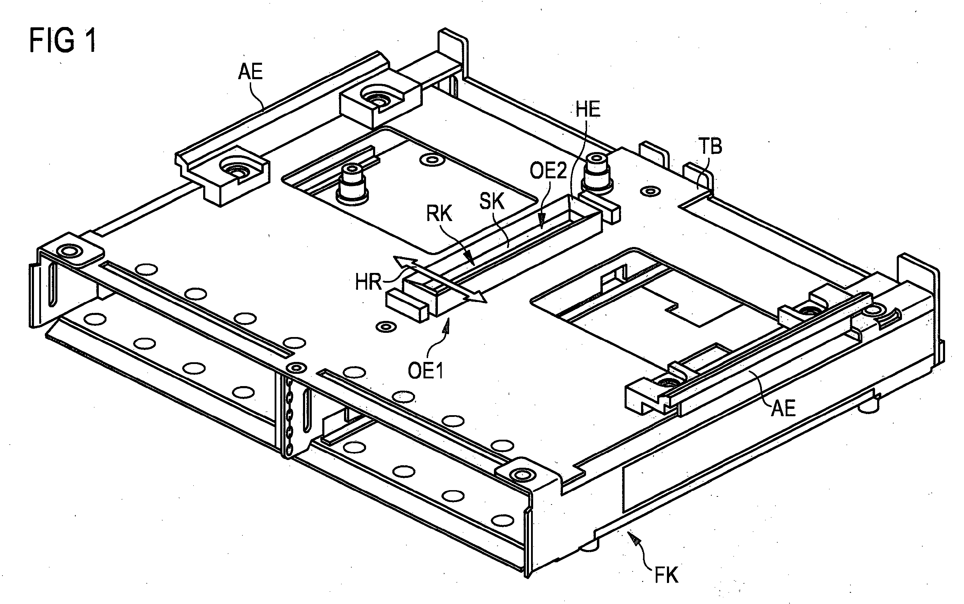

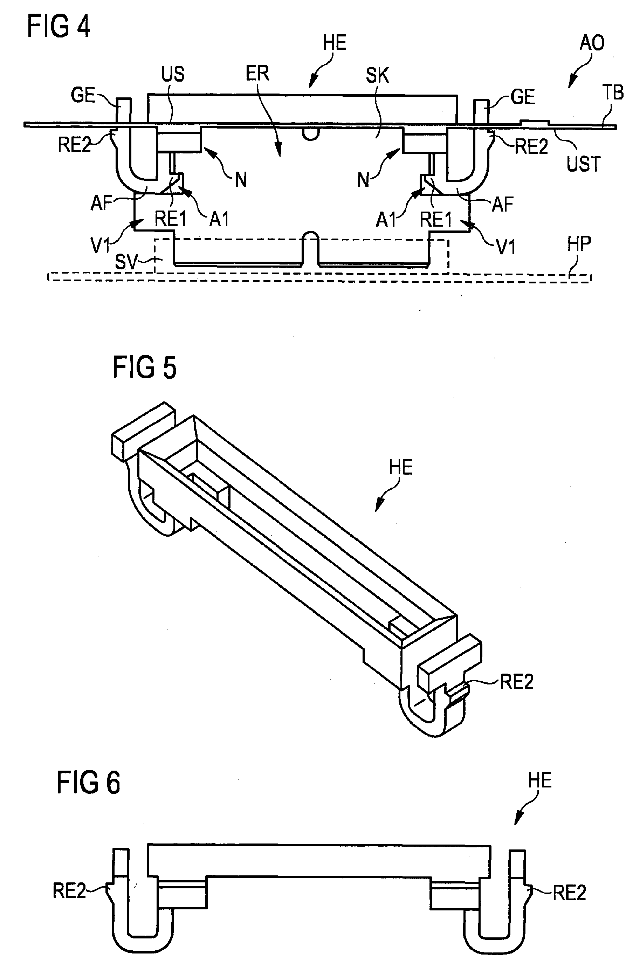

Figur 1 zeigt eine Anordnung AO für einen Bladeservereinschub gemäß einem ersten Ausführungsbeispiel. Die Anordnung AO weist einen Festplattenkäfig FK auf, welcher im Inneren des Bladeservereinschubs (nicht dargestellt) angeordnet und/oder mechanisch festgelegt ist. Beispielsweise ist der Festplattenkäfig FK mit der Hauptplatine HP verschraubt. Der Festplattenkäfig FK weist an einer Oberseite ein Trägerblech TB auf. Die Anordnung AO weist des Weiteren eine Riserkarte RK auf, welche in einen Steckverbinder einer Hauptplatine eingesteckt ist (siehe hierzu Figur 4). Die Hauptplatine ist unterhalb des Festplattenkäfigs FK angeordnet. Das Trägerblech TB weist eine erste Öffnung OE1 auf, welche fluchtend mit freiliegenden Steckkontakten SK der eingesteckten Riserkarte RK angeordnet ist. Die Anordnung AO weist des Weiteren ein Halteelement HE auf, welches eine zweite Öffnung OE2 aufweist. Das Halteelement HE ist mittels der zweiten Öffnung OE2 formschlüssig auf die Riserkarte RK aufgeschoben und mit dem Trägerblech TB im Bereich der ersten Öffnung OE1 verrastet. Dadurch ist die Riserkarte RK mechanisch sicher an dem Trägerblech TB festgelegt, wobei die freiliegenden Steckkontakte SK der Riserkarte RK über die zweite Öffnung OE2 von oben zugänglich sind. Die Anordnung AO weist zusätzlich zwei Auflagerelemente AE auf, welche im gezeigten Ausführungsbeispiel an dem Trägerblech TB mechanisch festgelegt sind, beispielsweise mittels Schraubverbindung, Nietverbindung oder einer sonstigen Verbindungstechnik.

Das Trägerblech TB muss nicht notwendigerweise Teil eines Festplattenkäfigs FK sein. Das Trägerblech TB kann alternativ ein separates Element sein, welches im Bladeservereinschub angebracht ist.

Das Halteelement HE weist mehrere Funktionen auf. Das Haltelement HE ist einerseits eingerichtet, die Riserkarte RK mechanisch sicher an dem Trägerblech TB festzulegen. Ist beispielsweise eine Erweiterungskarte auf die Riserkarte RK aufgesteckt, so verbleibt die Riserkarte RK bei der Demontage der Erweiterungskarte in dem Steckverbinder der Hauptplatine eingesteckt. Ein Abstecken der Riserkarte RK in vertikaler Richtung ist verhindert.

Zusätzlich soll ein Verkippen oder Verschwenken der vertikal angeordneten Riserkarte RK und/oder eine horizontale Bewegung der Riserkarte RK in horizontaler Richtung HR verhindert werden. Beispielsweise soll die Riserkarte RK nicht um einen Steckverbinder der Hauptplatine, in welchen die Riserkarte RK gesteckt ist, verschwenkt bzw. verkippt werden können.

Eine weitere Funktion des Halteelements HE ist es, dass das Gewicht einer eingesteckten Erweiterungskarte nicht vollständig auf die Riserkarte RK übertragen werden soll. Würde das Gewicht vollständig auf die Riserkarte RK übertragen werden, so würde ein Verkippen in horizontaler Richtung HR begünstigt werden. Zudem würde der Steckverbinder der Hauptplatine, in welchem die Riserkarte RK eingesteckt ist, sowie die Riserkarte RK selbst mechanisch belastet werden. Dies kann mechanische wie elektrische Schäden hervorrufen.

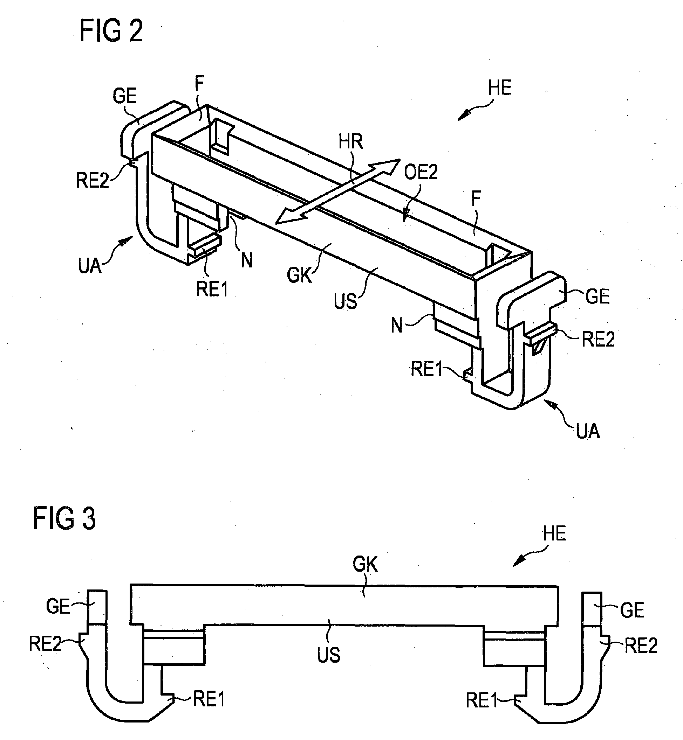

Eine weitere Funktion des Halteelements HE ist es, das Einstecken einer Erweiterungskarte an die Riserkarte RK zu erleichtern, sodass beispielsweise die richtige Einsteckposition für die Erweiterungskarte erreicht werden kann. Beispielsweise ist es somit ohne Probleme möglich, einen Steckverbinder der Erweiterungskarte korrekt in die zweite Öffnung OE2 einzusetzen und mit den Steckkontakten SK der Riserkarte RK zu verbinden. Dies wird beispielsweise durch das Vorsehen mehrerer Fasen F an dem Halteelement HE begünstigt (s. Figur 2).

Die Auflagerelemente AE sind dazu eingerichtet, eine eingesetzte Erweiterungskarte seitlich abzustützen und/oder die Montage einer Erweiterungskarte zu erleichtern.

Die Ausgestaltungen und Funktionen des Halteelements HE und der Auflagerelemente AE sind anhand der folgenden Figuren detailliert beschrieben.

Die Figuren 2 und 3 zeigen ein erstes Ausführungsbeispiel des in Figur 1 dargestellten Halteelements HE. Das Halteelement HE weist die zweite Öffnung OE2 auf, welche durchgängig in einen Grundkörper GK des Halteelements HE eingebracht ist. Die zweite Öffnung OE2 ist im Wesentlichen schlitzförmig und an einen Steckverbinder einer Erweiterungskarte und/oder an eine Form der Riserkarte RK angepasst. Im Inneren der zweiten Öffnung OE2 und/oder an einer Unterseite US des Halteelements HE sind zwei gegenüberliegende Nuten N, welche auch als Aussparungen oder Taschen bezeichnet werden können, ein- oder angebracht. Die Nuten N sind dazu eingerichtet, die Riserkarte RK seitlich zu führen beziehungsweise zu umgreifen. Dabei ist die Anordnung der Nuten N ist nicht auf das gezeigte Ausführungsbeispiel beschränkt und kann vielmehr verschiedenartig ausgeführt sein, um die seitliche Führung der Riserkarte RK zu gewährleisten. Ist das Halteelement HE beispielsweise auf die Riserkarte RK aufgeschoben, so kann die Riserkarte RK im Wesentlichen nicht in horizontaler Richtung HR verkippen oder verschwenkt sowie aus seiner vertikalen Position gebracht werden. Das Halteelement HE weist weiterhin erste Rastelemente RE1 und zweite Rastelemente RE2 auf, welche an einem U-förmigen Abschnitt UA angebracht sind. Der U-förmige Abschnitt UA ist aus dem Grundkörper GK herausgeformt.

Die Unterseite US ist in montiertem Zustand des Halteelements HE wie in Figur 1 gezeigt auf dem Trägerblech TB angeordnet. Die Unterseite US liegt dabei berührend auf dem Trägerblech TB auf. Somit kann die Gewichtskraft einer mit der Riserkarte RK verbundenen Erweiterungskarte über das Halteelement HE auf das Trägerblech TB abgegeben werden.

Die ersten Rastelemente RE1 und die zweiten Rastelemente RE2 sind federnd ausgestaltet. Dies liegt daran, dass der U-förmige Abschnitt UA elastisch, beispielsweise aufgrund eines elastischen Kunststoffwerkstoffes, ausgestaltet ist. Die ersten Rastelemente RE1 und die zweiten Rastelemente RE2 sind dazu eingerichtet, mit der Riserkarte RK beziehungsweise dem Trägerblech TB zu verrasten. Dies ist mit Hilfe der Figur 4 gezeigt.

Figur 4 zeigt eine schematische Seitenansicht der Anordnung AO gemäß Figur 1. Die Riserkarte RK ist dabei in einen Steckverbinder SV der Hauptplatine HP eingesteckt (gestrichelt dargestellt). Das Halteelement HE ist auf die Riserkarte RK aufgeschoben, wobei die Riserkarte RK durch die Nuten N im oberen Bereich seitlich umgriffen ist. Im eingeschobenen oder eingesteckten Zustand des Halteelements HE sind die ersten Rastelemente RE1 mit der Riserkarte RK verrastet, wobei die ersten Rastelemente RE1 im Wesentlichen formschlüssig in Aussparungen A1 der Riserkarte RK eingerastet sind. Die zweiten Rastelemente RE2 sind mit dem Trägerblech TB verrastet, wobei die zweiten Rastelemente RE2 durch die erste Öffnung OE1 des Trägerblechs TB hindurchgeführt sind und mit einer Unterseite UST des Trägerblechs TB verrasten. Ein Verkippen der Riserkarte RK um den Steckverbinder SV der Hauptplatine HP (in einer Richtung senkrecht zur Bildebene der Figur 4) ist somit nicht möglich.

Damit die Riserkarte RK nicht durch das Halteelement HE und die erste Öffnung OE1 des Trägerblechs entgegen einer Einsteckrichtung ER geführt werden kann, beispielsweise wenn eine auf die Riserkarte RK aufgesteckte Erweiterungskarte demontiert wird, weist die Riserkarte RK Vorsprünge V1 auf. Die Vorsprünge V1 sind berührend oder leicht beabstandet von Arretierflächen AF des Halteelements HE angeordnet. Dadurch, dass das Halteelement HE mit dem Trägerblech TB mittels der Unterseite US und den zweiten Rastelementen RE2 verrastet ist, kann die Riserkarte nicht demontiert werden, da die Vorsprünge V1 an den Arretierflächen AF des Halteelements HE beziehungsweise der U-förmigen Abschnitte UA aufliegen und ein Abstecken der Riserkarte RK entgegen der Einsteckrichtung ER verhindern und/oder blockieren. Somit ist die Riserkarte RK in vertikaler (senkrechter) Richtung bezüglich einer Erstreckungsebene der Hauptplatine HP festgelegt.

Wie in Figur 2 zu sehen ist, weist das Halteelement HE an Außenkanten, welche die zweite Öffnung OE2 begrenzen, eine oder mehrere Fasen F auf. Die Fasen F ermöglichen, dass ein Steckverbinder einer Erweiterungskarte richtig in die zweite Öffnung OE2 eingesetzt werden kann, sodass der Steckverbinder der Erweiterungskarte mit den Steckkontakten SK der Riserkarte RK verbunden werden kann. Die Fasen F bilden beispielsweise eine Trichterwirkung aus. Soll beispielsweise eine Erweiterungskarte auf die Riserkarte RK gesteckt werden, wobei die Riserkarte RK nur schwer zugänglich beziehungsweise der Steckverbinder der Erweiterungskarte aufgrund der Größe der Erweiterungskarte nur schwer einsehbar sind, so reicht es aus, den Steckverbinder der Erweiterungskarte ungefähr auf Höhe des Halteelements HE zu positionieren. Anschließend kann der Steckverbinder der Erweiterungskarte unter leichtem Druck in die richtige Position und in Kontakt mit der Riserkarte RK gebracht werden.

In einer nicht dargestellten Alternative kann das Halteelement HE auch keine Fasen F aufweisen und die Trichterwirkung und/oder Führung des Steckverbinders einer Einsteckkarte auch auf andere Art und Weise erzielen. Beispielsweise könnte der die zweite Öffnung OE2 begrenzte Rand stufenförmig ausgestaltet sein, wobei die Stufen zum Inneren der zweiten Öffnung OE2 hin abfallen.

Das Halteelement HE ist im gezeigten Ausführungsbeispiel einstückig gefertigt und weist einen Kunststoffwerkstoff auf. Beispielsweise kann ein solches Halteelement HE mittels eines Spritzgussverfahrens hergestellt werden. Somit ist das Halteelement HE auf einfache Weise herstellbar und kostengünstig. Alternativ kann das Halteelement HE auch aus einem anderen Werkstoff und/oder mehrteilig ausgeführt sein. Das Halteelement HE gemäß der Figuren 2 und 3 kann mittels der ersten Rastelemente RE1 mit der Riserkarte RK verrasten, sodass die Riserkarte RK und das Halteelement HE eine Einheit beziehungsweise eine Baugruppe bilden. So ist es zum Beispiel möglich, zunächst diese Baugruppe zu bilden und anschließend die Riserkarte RK mit Hilfe des an der Riserkarte RK festgelegten Halteelements HE in den Steckverbinder der Hauptplatine einzustecken. Dadurch, dass die erste Öffnung OE1 des Trägerblechs TB fluchtend mit der Riserkarte und somit mit dem Steckverbinder SV der Hauptplatine HP angeordnet ist, ist somit garantiert, dass die Riserkarte sicher an dem dafür vorgesehenen Steckverbinder SV der Hauptplatine HP eingesteckt wird.

Um das Aufschieben beziehungsweise Anstecken des Halteelements HE an die Riserkarte RK und/oder das Trägerblech TB zu erleichtern, weißt das Halteelement HE Griffelemente GE auf (s. Figur 4). Die Griffelemente GE sind an einem U-förmigen Abschnitten UA angeordnet. Beispielsweise können die Griffelemente GE an Außenseiten für eine bessere Haptik gerändelt sein. Zum Entriegeln und/oder Entrasten des Halteelements HE von dem Trägerblech TB und/oder der Riserkarte RK können die Griffelemente GE ebenfalls eingesetzt werden, wobei diese gegen den Grundkörper GK des Halteelements HE gedrückt werden können. Andere Ausgestaltungen der Griffelemente GE sind denkbar, beispielsweise können die Griffelement GE an anderer Position des Halteelements angeordnet sein.

Die Figuren 5 und 6 zeigen eine weitere, zweite Ausführungsform des Halteelements HE. Das darin gezeigte Halteelement HE weist im Wesentlichen dieselben Merkmale wie das Halteelement HE der Figuren 2 bis 4 auf, wobei das Halteelement HE keine ersten Rastelemente RE1 aufweist. Ein solches Halteelement HE kann somit vor der Montage der Riserkarte an der Hauptplatine nicht mechanisch fest und sicher an der Riserkarte RK festgelegt werden. Ein solches Halteelement HE setzt voraus, dass die Riserkarte RK bereits in die Hauptplatine eingesteckt ist. Dadurch kann eine kostengünstigere Herstellung eines Halteelements HE im Vergleich zu einem Halteelement HE gemäß der Figuren 2 bis 4 erzielt werden.

Das Halteelement HE, insbesondere die ersten und/oder zweiten Rastelemente RE1 und RE2 und/oder die U-förmigen Abschnitte UA, kann alternativ auch andersartig ausgestaltet sein. Solche Ausgestaltungsmöglichkeiten sind einem Fachmann geläufig, wobei zu beachten ist, dass die jeweiligen Funktionen eines Halteelements HE erfüllt sind.

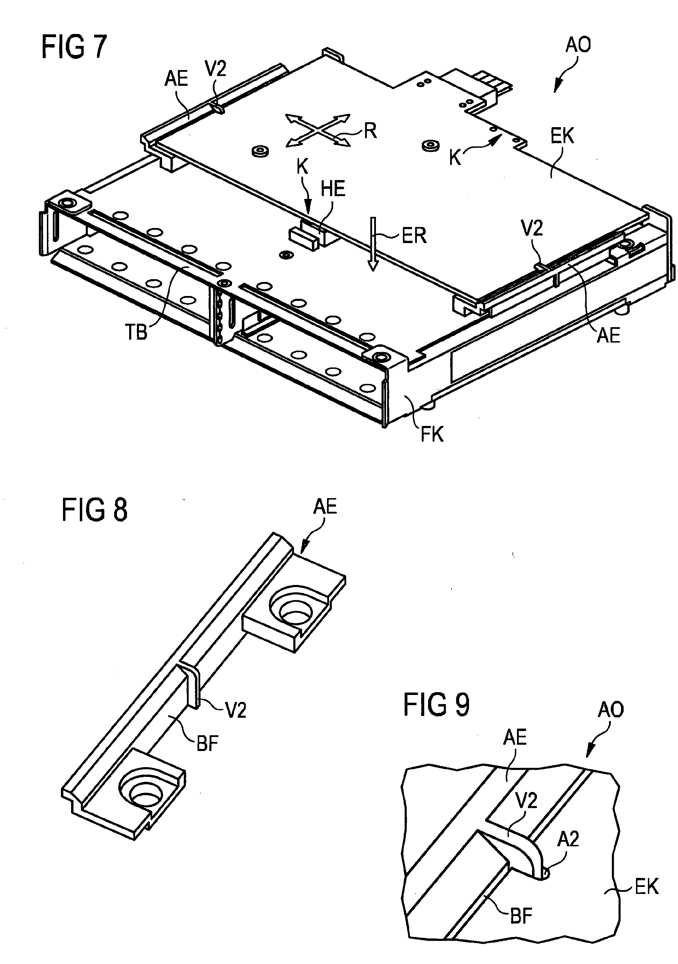

Figur 7 zeigt ein weiteres, zweites Ausführungsbeispiels einer Anordnung AO für einen Bladeservereinschub, welche im Wesentlichen die Merkmale der Anordnung AO gemäß Figur 1 aufweist. Zusätzlich weist die Anordnung AO eine Erweiterungskarte EK auf, welche in die zweite Öffnung OE2 des Halteelements HE eingeführt und auf die Steckkontakte der Riserkarte RK aufgesteckt ist. Die Erweiterungskarte EK liegt dabei auf dem Halteelement HE beziehungsweise den Außenkanten, welche die zweite Öffnung OE2 des Halteelements begrenzen, auf.

Somit kann das Gewicht der Erweiterungskarte EK über das Halteelement HE auf das Trägerblech TB verteilt werden. Das Gewicht der Erweiterungskarte EK ist somit nicht gänzlich der Riserkarte RK zugeführt beziehungsweise dem Steckverbinder SV der Hauptplatine HP. Dadurch werden mechanische Schäden an der Riserkarte RK und der Hauptplatine HP vermieden. Die Anordnung AO ermöglicht, dass die Erweiterungskarte EK sicher mit der Riserkarte RK verbunden werden kann, trotz des engen und begrenzten Bauraumes beziehungsweise des Formfaktors eines Bladeservereinschubs. Die Kühlung eines Bladeservereinschubs, welche im Wesentlichen parallel zu der Erstreckungsebene der Erweiterungskarte EK verläuft, wird somit im Wesentlichen nicht beeinflusst oder behindert. Der Steckverbinder der Erweiterungskarte EK kann sicher auf die Riserkarte RK aufgesteckt werden. Auch wenn die Steckkontakte SK der Riserkarte RK und/oder der Steckverbinder der Erweiterungskarte EK nicht einsehbar sind, reicht es aus, den Steckverbinder der Erweiterungskarte EK ungefähr auf Höhe des Halteelements HE zu positionieren, wobei der Steckverbinder beispielsweise aufgrund der Fasen F des Halteelements HE in die zweite Öffnung OE2 geführt und mit den Steckkontakten der Riserkarte RK verbunden werden kann.

Figur 7 zeigt zusätzlich zwei Auflagerelemente AE, welche im Vergleich zu Figur 1 zusätzlich jeweils einen Vorsprung V2 aufweisen. Die Auflagerelemente AE sind in Figur 8 detailliert dargestellt.

Figur 8 zeigt ein Auflagerelement AE gemäß der Anordnung AO aus Figur 7. Das Auflagerelement AE weist den Vorsprung V2 auf, welcher dazu eingerichtet ist, in einer Aussparung A2 der Erweiterungskarte EK formschlüssig geführt zu werden. Dies ist anhand einer vergrößerten Darstellung in Figur 9 zu sehen. Der Vorsprung V2 ist dabei formschlüssig in der Aussparung A2 aufgenommen.

Beispielsweise kann bei einer Montage der Erweiterungskarte EK die Erweiterungskarte EK auf Höhe der Auflagerelemente AE gebracht werden, sodass die Erweiterungskarte mittels der Aussparungen A2 mit den Vorsprüngen V2 der Auflagerelemente A2 formschlüssig verbunden ist. Anschließend kann die Erweiterungskarte EK in Einsteckrichtung ER nach unten gedrückt werden, sodass der Steckverbinder der Erweiterungskarte EK mit der Riserkarte RK korrekt und sicher verbunden wird. Die Erweiterungskarte EK liegt dabei mit Außenseiten an Begrenzungsflächen BF der Auflagerelemente AE an. Damit ist gewährleistet, dass die Erweiterungskarte EK in ihrer Erstreckungsebene in alle Richtungen R festgelegt ist und somit bis auf einen Freiheitsgrad alle Freiheitsgrade unterdrückt sind. Der eine, freie Freiheitsgrad entspricht der Absteckrichtung der Erweiterungskarte entgegen der Einsteckrichtung ER. Während des Betriebes kann dieser Freiheitsgrad beispielsweise durch einen Gehäusedeckel des Bladeservereinschubs unterdrückt sein. Ein Verschieben der Erweiterungskarte EK in den Richtungen R ist auch durch das Halteelement HE blockiert.

Zusätzlich können bei einer Erweiterungskarte EK auf Höhe des Steckverbinders beziehungsweise des Halteelements HE Kerben K in Außenkanten der Erweiterungskarte EK eingebracht sein, damit die Erweiterungskarte EK auf einfache Weise eingesteckt, also montiert, und/oder demontiert werden kann. Mittels der Kerben K kann die Erweiterungskarte EK besser gegriffen werden. Die Kerben K können auch als Mulden ausgestaltet sein oder andere Ausführungsformen annehmen.

Die Erfindung ist nicht auf die angegebenen Ausführungsbeispiele beschränkt. Insbesondere ist es möglich, die Merkmale beziehungsweise Funktionen der verschiedenen Ausführungsbeispiele miteinander zu kombinieren, um die jeweiligen Vorteile oder Funktionen zu erhalten.

### Bezugszeichenliste

- A1: Aussparung
- A2: Aussparung
- AE: Auflagerelement
- AF: Arretierfläche
- AO: Anordnung
- BF: Begrenzungsfläche
- EK: Erweiterungskarte
- ER: Einsteckrichtung
- F: Fase
- FK: Festplattenkäfig
- GE: Griffelement
- GK: Grundkörper
- HE: Halteelement
- HP: Hauptplatine
- HR: horizontale Richtung
- K: Kerbe
- N: Nut
- OE1: Öffnung
- OE2: Öffnung
- R: Richtung
- RE1: Rastelemente
- RE2: Rastelemente
- RK: Riserkarte
- SK: Steckkontakte
- SV: Steckverbinder
- TB: Trägerblech
- UA: U-förmiger Abschnitt
- US: Unterseite
- UST: Unterseite
- V1: Vorsprung
- V2: Vorsprung

## Patentansprüche

1. Anordnung (AO) für einen Bladeservereinschub, aufweisend
- eine Hauptplatine (HP) mit einem Steckverbinder (SV);
- eine in den Steckverbinder (SV) der Hauptplatine (HP) eingesteckte Riserkarte (RK);
- ein in dem Bladeservereinschub im Wesentlichen parallel zu der Hauptplatine (HP) festgelegtes Trägerblech (TB) mit einer ersten Öffnung (OE1), welche fluchtend mit freiliegenden Steckkontakten (SK) der eingesteckten Riserkarte (RK) angeordnet ist; und
- ein Halteelement (HE);
**dadurch gekennzeichnet, dass**
das Halteelement (HE) einen Grundkörper (GK) mit einer durchgängigen, zweiten Öffnung (OE2) aufweist, wobei das Halteelement (HE) dazu eingerichtet ist, mittels der zweiten Öffnung formschlüssig auf die Riserkarte (RK) aufgeschoben zu werden und mit dem Trägerblech (TB) zu verrasten, sodass die Riserkarte (RK) mechanisch sicher an dem Trägerblech (TB) festgelegt ist und die Steckkontakte (SK) der Riserkarte (RK) über die zweite Öffnung (OE2) zugänglich sind.

2. Anordnung (AO) nach Anspruch 1, weiter aufweisend eine Erweiterungskarte (EK), welche dazu eingerichtet ist, mittels eines Steckverbinders der Erweiterungskarte (EK) in die zweite Öffnung (OE2) des Halteelements (HE) zum Verbinden mit den Steckkontakten (SK) der Riserkarte (RK) derart eingesteckt zu werden, dass die Erweiterungskarte (EK) auf einer die zweite Öffnung (OE2) des Halteelements (HE) aufweisenden Seite des Halteelements (HE) aufliegt.

3. Anordnung (AO) nach einem der Ansprüche 1 oder 2, wobei die Steckkontakte (SK) der Riserkarte (RK) im Wesentlichen innerhalb der zweiten Öffnung (OE2) des Halteelements (HE) angeordnet sind.

4. Anordnung (AO) nach einem der Ansprüche 1 bis 3, wobei der Grundkörper (GK) des Halteelements (HE) wenigstens zwei federnde Rastelemente (RE1) aufweist und die Riserkarte (RK) wenigstens zwei Aussparungen (A1) aufweist, sodass die wenigstens zwei Rastelemente (RE1) beim Aufschieben des Halteelements (HE) auf die Riserkarte (RK) in den wenigstens zwei Aussparungen (A1) verrasten und das Halteelement (HE) mechanisch sicher mit der Riserkarte (RK) gekoppelt ist.

5. Anordnung (AO) nach einem der Ansprüche 1 bis 4, wobei der Grundkörper (GK) des Halteelements (HE) wenigstens zwei federnde Rastelemente (RE2) zum Verrasten des Halteelements (HE) mit dem Trägerblech (TB) aufweist.

6. Anordnung (AO) nach Anspruch 4, wobei der Grundkörper (GK) des Halteelements (HE) wenigstens zwei federnde Rastelemente (RE2) zum Verrasten des Halteelements (HE) mit dem Trägerblech (TB) aufweist und wobei aus dem Grundkörper (GK) des Halteelements (HE) zwei U-förmige, gegenüberliegende Abschnitte (UA) herausgeformt sind, wobei an einem U-förmigen Abschnitt (UA) jeweils eins der zwei federnden Rastelemente (RE1) welche in den wenigstens zwei Aussparungen (A1) verrasten und jeweils eins der zwei federnden Rastelemente(RE2) zum Verrasten des Halteelements (HE) mit dem Trägerblech angeordnet sind.

7. Anordnung (AO) nach einem der Ansprüche 2 bis 6, wobei der Steckverbinder der Erweiterungskarte (EK) formschlüssig in der zweiten Öffnung (OE2) des Halteelements (HE) aufnehmbar ist.

8. Anordnung (AO) nach einem der Ansprüche 1 bis 7, wobei das Halteelement (HE) an Außenkanten, welche die zweite Öffnung (OE2) begrenzen, eine oder mehrere Fasen (F) aufweist.

9. Anordnung (AO) nach einem der Ansprüche 1 bis 8, wobei das Halteelement (HE) im Bereich der zweiten Öffnung (OE2) zwei Nuten (N) aufweist, welche gegenüberliegend angeordnet sind und dazu eingerichtet sind, die Riserkarte (RK) seitlich zu umgreifen.

10. Anordnung (AO) nach einem der Ansprüche 1 bis 9, wobei das Trägerblech (TB) ein Seitenteil eines Festplattenkäfigs (FK) ist.

11. Anordnung (AO) nach einem der Ansprüche 2 bis 10, weiter aufweisend wenigstens ein Auflagerelement (AE), welches im Bladeservereinschub angeordnet ist und dazu eingerichtet ist, eine in die zweite Öffnung (OE2) des Halteelements (HE) eingesteckte Erweiterungskarte (EK) abzustützen.

12. Anordnung (AO) nach Anspruch 11, wobei das wenigstens eine Auflagerelement (AE) parallel zu einer Einsteckrichtung (ER) der Erweiterungskarte (EK) einen Vorsprung (V2) aufweist und die Erweiterungskarte (EK) eine oder mehrere Aussparungen (A2) aufweist, wobei beim Einstecken der Erweiterungskarte (EK) der Vorsprung (V2) des wenigstens einen Auflagerelements (AE) formschlüssig in einer entsprechenden Aussparung (A2) aufgenommen ist.

13. Anordnung (AO) nach einem der Ansprüche 1 bis 12, wobei das Halteelement (HE) einstückig und/oder aus einem Kunststoffwerkstoff hergestellt ist.

## Claims

1. An arrangement (AO) for a blade server slide-in module, comprising:
- a motherboard (HP) having a plug connector (SV);
- a riser card (RK) inserted into the plug connector (SV) of the motherboard (HP);
- a carrier plate (TB) having a first opening (OE1) and which is fixed essentially parallel to the motherboard (HP) in the blade server slide-in module, which first opening (OE1) is arranged to be aligned with the exposed plug contacts (SK) of the inserted riser card (RK); and
- a retaining element (HE),
**characterized in that**
the retaining element (HE) comprises a main body (GK) with a continuous second opening (OE2), wherein the retaining element (HE) is set-up to be pushed on the riser card (RK) in a form-fit manner by means of the second opening (OE2) and to latch with the carrier plate (TB), so that the riser card (RK) is fixed to the carrier plate (TB) in a mechanically secure manner and the plug contacts (SK) of the riser card (RK) are accessible via the second opening (OE2).

2. The arrangement (AO) according to claim 1, further comprising an expansion card (EK) which is set-up for being plugged by a plug connector of the expansion card (EK) into the second opening (OE2) of the retaining element (HE) to connect with the plug contacts (SK) of the riser card (RK) such that the expansion card (EK) rests on a side of the retaining element (HE) comprising the second opening (OE2) of the retaining element (HE).

3. The arrangement (AO) according to one of claims 1 or 2, wherein the plug contacts (SK) of the riser card (RK) are arranged substantially inside the second opening (OE2) of the retaining element (HE).

4. The arrangement (AO) according to one of claims 1 to 3, wherein the main body (GK) of the retaining element (HE) has at least two resilient catch elements (RE1) and the riser card (RK) has at least two recesses (A1) so that the at least two catch elements (RE1) lock into the at least two recesses (A1) when the retaining element (HE) is pushed onto the riser card (RK) and the retaining element (HE) is securely mechanically coupled to the riser card (RK).

5. The arrangement (AO) according to one of claims 1 to 4, wherein the main body (GK) of the retaining element (HE) has at least two resilient catch elements (RE2) to lock the retaining element (HE) to the carrier plate (TB).

6. The arrangement (AO) according to claim 4, wherein the main body (GK) of the retaining element (HE) has at least two resilient catch elements (RE2) for locking the retaining element (HE) to the carrier plate (TB), and wherein two U-shaped segments (UA) lying opposite each other are molded from the main body (GK) of the retaining element (HE), wherein a U-shaped segment (UA) has arranged thereon in each case one of the two resilient catch elements (RE1) which lock in the at least two recesses (A1) and in each case one of the two resilient catch elements (RE2) for locking the retaining element (HE) with the carrier plate.

7. The arrangement according to one of claims 2 to 6, wherein the plug connector of the expansion card (EK) can be received in a form-fit manner in the second opening (OE2) of the retaining element (HE).

8. The arrangement (AO) according to one of claims 1 to 7, wherein at outer edges that define the second opening (OE2) the retaining element (HE) has one or more bevels (F).

9. The arrangement (AO) according to one of claim 1 to 8, wherein, in the region of the second opening (OE2) the retaining element (HE) has two grooves (N) arranged opposite and set-up to engage laterally around the riser card (RK).

10. The arrangement (AO) according to one of claims 1 to 9, wherein the carrier plate (TB) is a side part of a hard drive cage (FK).

11. The arrangement (AO) according to one of claims 2 to 10, further comprising at least one support element (AE) arranged in the blade server slide-in module and set up to support an expansion card (EK) inserted into the second opening (OE2) in the retaining element (HE).

12. The arrangement (AO) according to claim 11, wherein the at least one support element (AE) comprises a projection (V2) parallel to an insertion direction (ER) of the expansion card (EK) and the expansion card (EK) comprises one or more recesses (A2), wherein upon insertion of the expansion card (EK) the projection (V2) of the at least one support element (AE) is received in a form-fit manner in a corresponding recess (A2).

13. The arrangement (AO) according to one of claims 1 to 12, wherein the retaining element (HE) is produced in one piece and/or from a plastics material.

## Revendications

1. Un ensemble (AO) pour un module serveur lame insérable, comprenant:
- une carte mère (HP) ayant un connecteur (SV);
- une carte adapteur (RK) enfichée dans le connecteur (SV) de la carte mère (HP);
- une tôle support (TB) ayant une première ouverture (OE1) et fixée de manière essentiellement parallèle à la carte mère (HP) dans le module serveur lame insérable, ladite ouverture étant disposée de sorte à être alignée avec les contacts enfichables (SK) exposés de la carte adaptateur enfichée (RK); et
- un élément de retenue (HE),
**caractérisé en ce que**
l'élément de retenue (HE) comprend un corps de base (GK) avec une deuxième ouverture continue (OE2), dans lequel l'élément de retenue (HE) est adapté à être pressé sur la carte adaptateur (RK) par un ajustage serré à l'aide de la deuxième ouverture et pour être verrouillé avec la tôle support (TB), pour que la carte adaptateur (RK) soit fixée à la tôle support (TB) mécaniquement et en toute sécurité, et les contacts enfichables (SK) de la carte adaptateur (RK) soient accessibles à travers la deuxième ouverture (OE2).

2. L'ensemble (AO) selon la revendication 1, comprenant en outre une carte d'extension (EK) adaptée à être fichée par un connecteur de la carte d'extension (EK) dans la deuxième ouverture (OE2) de l'élément de retenue (HE), pour être relié aux contacts enfichables (SK) de la carte adaptateur (RK) de manière telle que la carte d'extension (EK) repose sur un côté de l'élément de retenue (HE) qui contient la deuxième ouverture (OE2) de l'élément de retenue (HE).

3. L'ensemble (AO) selon une des revendications 1 ou 2, dans lequel les contacts enfichables (SK) de la carte adaptateur (RK) sont disposés essentiellement à l'intérieur de la deuxième ouverture (OE2) de l'élément de retenue (HE).

4. L'ensemble (AO) selon une des revendications 1 à 3, dans lequel le corps de base (GK) de l'élément de retenue (HE) possède au moins deux éléments résilients d'encliquetage (RE1) et la carte adaptateur (RK) possède au moins deux évidements (A1), de sorte que lesdits au moins deux éléments d'encliquetage RE1) se verrouillent dans lesdites au moins deux évidements (A1) lorsque l'élément de retenue (HE) est pressé vers la carte adaptateur (RK), et que l'élément de retenue (HE) est couplé mécaniquement et en toute sécurité avec la carte adaptateur (RK).

5. L'ensemble (AO) selon une des revendications 1 à 4, dans lequel le corps de base (GK) de l'élément de retenue (HE) possède au moins deux éléments résilients d'encliquetage (RE2) pour verrouiller l'élément de retenue (HE) avec la tôle support (TB).

6. L'ensemble (AO) selon la revendication 4, dans lequel le corps de base (GK) de l'élément de retenue (HE) possède au moins deux éléments résilients d'encliquetage (RE2) afin de verrouiller l'élément de retenue (HE) avec la tôle support (TB), et dans lequel deux segments en forme de U opposés (UA) sont moulés à partir du corps de base (GK) de l'élément de retenue (HE), dans lequel un segment en forme de U (UA) a disposé là-dessus dans chaque cas un des deux éléments résilients d'encliquetage (RE1) qui se verrouillent dans lesdites au moins deux évidements (A1) et, dans chaque cas, un des deux éléments résilients d'encliquetage (RE2) afin de verrouiller l'élément de retenue (HE) avec la plaque de support.

7. L'ensemble selon une des revendications 2 à 6, dans lequel le connecteur de la carte d'extension (EK) peut être reçu par un ajustage serrage du moule dans la deuxième ouverture (OE2) de l'élément de retenue (HE).

8. L'ensemble (AO) selon une des revendications 1 à 7, dans lequel sur les bords externes qui délimitent la deuxième ouverture (OE2), l'élément de retenue (HE) possède un ou plusieurs chanfreins (F).

9. L'ensemble (AO) selon une des revendications 1 à 8, dans lequel, dans une zone de la deuxième ouverture (OE2), l'élément de retenue (HE) a deux rainures (N) disposées de façon opposée et configurées pour s'engager de façon latérale autour de la carte adaptateur (RK).

10. L'ensemble (AO) selon une des revendications 1 à 9, dans lequel la tôle support (TB) est une partie latérale d'une cage du disque dur (FK).

11. L'ensemble (AO) selon une des revendications 2 à 10, comprenant en outre au moins un élément de support (AE) disposé dans le module serveur lame insérable et adapté à supporter une carte d'extension (EK) insérée dans la deuxième ouverture (OE2) de l'élément de retenue (HE).

12. L'ensemble (AO) selon la revendication 11, dans lequel l'au moins un élément de support (AE) comprend une saillie (V2) parallèle à une direction d'insertion (ER) de la carte d'extension (EK) et la carte d'extension (EK) comprend un ou plusieurs évidements (A2), dans lequel suite à l'insertion de la carte d'extension (EK) la saillie (V2) dudit au moins un élément de support (AE) est reçu par un ajustage serrée dans un évidement correspondant (A2).

13. L'ensemble (AO) selon une des revendications 1 à 12, dans lequel l'élément de retenue (HE) est fabriqué en une seule pièce et/ou à partir d'une matière plastique.
